(19) Europäisches Patentamt

European Patent Office

Office européen des brevets

(11) Veröffentlichungsnummer: **0 149 786**
**B1**

(12) **EUROPÄISCHE PATENTSCHRIFT**

(45) Veröffentlichungstag der Patentschrift:
**11.05.88**

(21) Anmeldenummer: **84115182.2**

(22) Anmeldetag: **11.12.84**

(51) Int. Cl.⁴: **H 01 L 23/42**

(54) **Leistungshalbleitermodul.**

(30) Priorität: **21.01.84 DE 3402003**

(43) Veröffentlichungstag der Anmeldung:
**31.07.85 Patentblatt 85/31**

(45) Bekanntmachung des Hinweises auf die Patenterteilung:
**11.05.88 Patentblatt 88/19**

(84) Benannte Vertragsstaaten:
**AT CH DE FR GB IT LI NL SE**

(56) Entgegenhaltungen:
**GB - A - 2 039 416**

**IBM TECHNICAL DISCLOSURE BULLETIN, Band 22, Nr. 3, August 1979, Seiten 1026-1028, New York, US; S. OKTAY et al.: "Compliant heat pipe for cooling semiconductor chips"**

(73) Patentinhaber: **BROWN, BOVERI & CIE Aktiengesellschaft, Kallstadter Strasse 1, D-6800 Mannheim 31 (DE)**

(72) Erfinder: **Bunk, Klaus, Paulusstrasse 3, D-6520 Worms (DE)**
Erfinder: **Gobrecht, Jens, Dr. Dipl.-Phys., Birchhof 6, CH-5412 Gebenstorf (CH)**
Erfinder: **Neidig, Arno, Dr. Dipl.-Phys., Brühlerweg 42, D-6831 Plankstadt (DE)**

(74) Vertreter: **Kempe, Wolfgang, Dr. et al, c/o BROWN, BOVERI & CIE AG ZPT Postfach 351, D-6800 Mannheim 31 (DE)**

## Beschreibung

Die Erfindung bezieht sich auf Leistungshalbleitermodule gemäss dem Oberbegriff des Anspruchs 1. Dabei handelt es sich um Module mit Leistungshalbleitern, die in Lötkontakttechnik elektrisch isoliert auf einem Substrat aufgebaut sind.

Solche Leistungshalbleitermodule sind z.B. aus den deutschen Offenlegungsschriften 31 27 457 und 30 28 178 bekannt. Bei der Abfuhr hoher Verlustleistungen aus den Halbleiteraktivteilen stört jedoch der hohe innere Wärmewiderstand der Module, der zu einem grossen Teil durch die isolierenden Keramiksubstrate verursacht ist. Module mit Leistungshalbleiterbauelementen für Dauerströme über etwa 100 Ampere werden bisher ausschliesslich in Druckkontakttechnik hergestellt, weil dabei die Probleme der Fehlanpassung von thermischen Ausdehnungen besser beherrscht werden.

Module in Druckkontakttechnik erfordern jedoch einen hohen Material- und Montageaufwand, da die hohen Druckkräfte einen massiven Aufbau notwendig machen. Kontaktflächen müssen sehr eben sein. Ausserdem wird zur elektrischen Isolierung bei gleichzeitig geringem Wärmewiderstand das teuere Berylliumoxid verwendet, das als Staub giftig ist und dadurch Verschrottungsprobleme verursacht.

Aus der GB-A-2 039 416 ist ein Halbleitermodul bekannt mit einem Keramiksubstrat, das als Wärmerohr ausgebildet ist. Das Keramiksubstrat ist ausgehöhlt, mit einer Kapillarstruktur ausgekleidet und mit etwas Arbeitsflüssigkeit gefüllt. In Bohrungen des Substrats sind lateral strukturierte Halbleiterbauelemente (integrierte Schaltungen) eingelötet.

Ausgehend von diesem Stand der Technik liegt der vorliegenden Erfindung die Aufgabe zugrunde, die Wärmeabfuhr bei Leistungshalbleitermodulen mit Substraten aus metallisierten Aluminiumoxidkeramiken und aufgelöteten Leistungshalbleiterbauelementen unter Vermeidung der Nachteile bekannter Lösungen zu verbessern und den inneren Wärmewiderstand zwischen Silizium-Aktivteil und Gehäuseboden zu verringern. Daraus ergeben sich erhebliche Vorteile durch bessere Nutzung der Siliziumfläche und durch geringeren Kühlaufwand.

Diese Aufgabe wird durch Leistungshalbleitermodule gemäss Anspruch 1 gelöst. Mit der Erfindung wird vorgeschlagen, den Transport der Verlustwärme von einem Halbleiterbauelement durch ein elektrisch isolierendes Substrat zu einem Kühlkörper dadurch zu verbessern, dass in Metallschichten zwischen dem Halbleiterbauelement und dem Keramiksubstrat ein Wärmerohr integriert wird zur Verteilung der Wärme auf eine grössere Substratfläche. Dadurch kann der Wärmewiderstand vorteilhaft verringert werden.

Wärmerohre (heat-pipies) sind allgemein bekannt und sind z.B. in den BBC-Nachrichten, 1966, Seite 206 bis 211 beschrieben. Es handelt sich dabei um einen geschlossenen Raum, der teilweise mit einer Flüssigkeit gefüllt ist. Das Wandmaterial und die Art der Flüssigkeit hängen im wesentlichen vom Temperaturbereich ab, in dem das Wärmerohr arbeiten soll. Bei Wärmezufuhr an einer Stelle des Wärmerohres (Heizzone) verdampft die Flüssigkeit und der Dampf verteilt sich über den gesamten Innenraum. An einer Wärmesenke kondensiert der Dampf und gibt dabei Wärme ab. Die Arbeitsflüssigkeit muss zur Heizzone zurück transportiert werden. Dies kann mit Hilfe der Schwerkraft geschehen, wenn man das Wärmerohr so anordnet, dass die Heizzone unten und die Wärmesenke weiter oben ist. Der Rücktransport der Flüssigkeit kann jedoch auch durch Kapillarkraft erfolgen, wozu die Innenwand mit Rillen oder einer porösen Schicht versehen wird. Das Wärmerohr zeichnet sich dadurch aus, dass die Wärme von einer Wärmequelle zu einer weiter entfernten und/oder grossflächigen Wärmesenke bei nur geringem Temperaturabfall transportiert werden kann. Die von dem sogenannten Wärmerohr gebildete Kammer muss keineswegs zylindrisch sein; ein Wärmerohr kann eine nahezu beliebige Form haben.

Bei der hier vorgeschlagenen Anwendung des Wärmerohrprinzips wird die Metallisierung auf der dem Halbleiterbauelement zugewandten Seite des Substrats als Wärmerohr ausgebildet, damit sich der Wärmestrom auf eine möglichst grosse Fläche der schlecht wärmeleitenden Keramik verteilt.

Wenn das Leistungshalbleitermodul stets in einer definierten Einbaulage angewendet wird, kann das Wärmerohr sehr einfach ohne Kapillarstruktur ausgebildet werden, da dann die Schwerkraft für den Rücktransport der Flüssigkeit sorgt. Ein solches Wärmerohr kann durch eine strukturierte Metallfolie auf einer Keramikplatte und eine glatte Metallfolie als Deckfolie über der strukturierten Folie hergestellt werden.

Gemäss einer vorteilhaften Ausgestaltung kann das Wärmerohr mit einer Kapillarstruktur versehen werden, wodurch das Leistungshalbleitermodul in beliebiger Einbaulage angewendet werden kann. Eine solche Kapillarstruktur kann in die Deckfolie geätzt werden.

Eine vorteilhafte Weiterentwicklung der als Wärmerohr mit Kapillarstruktur ausgebildeten Metallisierung besteht darin innerhalb des Wärmerohres eine Struktur aus billiger Aluminiumoxidkeramik vorzusehen. Damit können in der Heizzone grössere Räume für den Dampfstrom geschaffen werden, ausserdem wird die mechanische Festigkeit der Anordnung verbessert.

Eine vorteilhafte Ausführungsvariante eines in die Metallisierung des Substrats integrierten Wärmerohres besteht darin, eine Kupferfolie zu verwenden, in die einseitig sowohl Dampfkanäle als auch Kapillarrillen geätzt sind und die mit der geätzten Seite direkt mit einer zuvor nichtmetallisierten Keramikplatte verbunden wird. Damit wird ein einfacher Aufbau des Substrats erreicht, wenn geringere Verlustleistungen unterhalb etwa 100 Watt verteilt werden müssen.

2

Da eine als Wärmerohr ausgebildete Metallisierung dicht sein und einem gewissen Dampfdruck standhalten muss, wird vorteilhaft ein Substrat verwendet, das nach einem Direct-Bonding-Verfahren hergestellt ist. Probleme der Fehlanpassung thermischer Ausdehnungen zwischen Silizium-Aktivteil und benachbarten Schichten sind dabei gering, da die Keramik wesentlich den Ausdehnungskoeffizienten bestimmt.

Zur Erläuterung der Erfindung werden nachstehend anhand der Zeichnung Ausführungsbeispiele beschrieben.

Es zeigen:

Fig. 1 Substrat mit als Wärmerohr ohne Kapillaren ausgebildeten Metallisierungen (Beispiel 1),

Fig. 2 Schnitt durch eine in Fig. 1 eingetragene Ebene A–B eines Substrats mit aufgelötetem Thyristor,

Fig. 3 Substrat mit als Wärmerohr ausgebildeter Metallisierung, wobei Kapillaren vorgesehen sind, die strahlenförmig von der Heizzone des Wärmerohres ausgehen (Beispiel 2),

Fig. 4 Schnitt durch die in Fig. 3 eingetragene Ebene C–D im Substrat,

Fig. 5 Schnitt durch eine als Wärmerohr mit Kapillarstruktur ausgebildete Metallisierung auf einer Keramikplatte, wobei innerhalb der Metallisierung eine strukturierte zweite Keramikplatte enthalten ist (Beispiel 3),

Fig. 6 Schnitt durch eine als Wärmerohr mit Kapillarstruktur ausgebildete Metallisierung auf einer Keramikplatte, wobei die Metallisierung aus nur einer Folie besteht, die sowohl Kapillaren als auch Dampfkanäle aufweist (Beispiel 4),

Fig. 7 Schnitt durch eine als Wärmerohr mit Kapillarstruktur ausgebildete Metallisierung auf einer Keramikplatte, wobei eine poröse Keramikplatte als Kapillarstruktur wirkt (Beispiel 5).

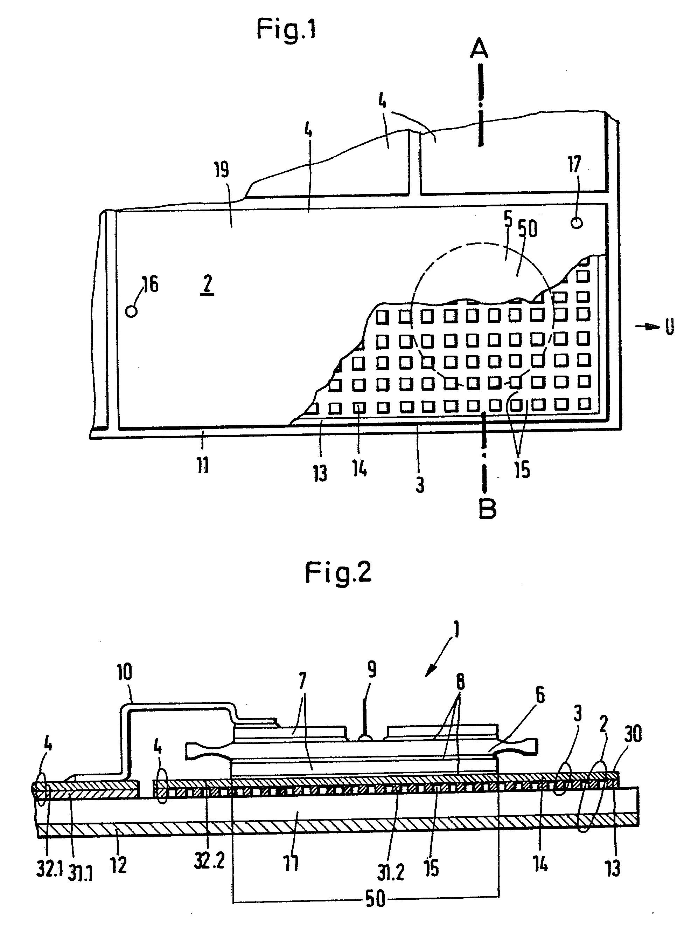

In Fig. 1 ist ein erstes Ausführungsbeispiel für ein Substrat 2 mit Metallisierungen 4 dargestellt, von denen einige als Wärmerohr 3 ausgebildet sind. Der mit gestrichelter Linie eingetragene Kreis deutet die angenommene Heizzone 50 eines Wärmerohres 3 an. Das ist die Stelle, an der ein Leistungshalbleiterbauelement 6 mit seiner Grundfläche 5 aufgelötet wird, wie in Fig. 2 dargestellt.

Fig. 2 zeigt einen Schnitt durch die in Fig. 1 eingetragene Schnittebene A–B. Dieser in Fig. 2 dargestellte Schnitt durch einen Leistungshalbleitermodul 1 zeigt ein Substrat 2 mit zwei Metallisierungen 4, wovon die rechts dargestellte Metallisierung als Wärmerohr 3 ausgebildet ist. Auf das Wärmerohr 3 ist ein sogenannter Sandwich aufgelötet, der aus einem Leistungshalbleiterbauelement 6 (Thyristor), Kontaktronden 7 aus Molybdän und Lotschichten 8 besteht und einen Gate-Anschluss 9 aufweist. Ein Kontaktbügel 10 verbindet die Kathodenseite des Halbleiterbauelements 6 mit einer Metallisierung 4.

Die weitere Beschreibung des in den Figuren 1 und 2 dargestellten Ausführungsbeispiels erfolgt im Rahmen der nachstehenden Beschreibung einer Herstellung des Leistungshalbleitermodul 1.

Man geht von einer etwa 0,63 bis 1,0 mm dicken Keramikplatte 11 aus, die auf beiden Seiten mit je einer etwa 0,3 mm dicken Kupferfolie 12, 31.1, 31.2 verbunden wird (Direct-Bonding-Verfahren). Die Kupferfolie 31.1, 31.2 auf der Oberseite der Keramik 11 wird im Bereich der später entstehenden Teil-Folie 31.2 so geätzt, dass innerhalb eines geschlossenen Randes 13 quadratische Kupferflächen 14 mit etwa 0,4 mm Kantenlänge stehen bleiben. Für die Ätzung ist eine Maskierung in Siebdrucktechnik geeignet. Die Zwischenräume 15 zwischen den Kupferflächen 14 sind etwa 0,6 mm breit.

Im zweiten Arbeitsgang wird auf die strukturierte Kupferfolie 31.1, 31.2 eine weitere etwa 0,3 mm dicke Kupferfolie 32.1, 32.2 durch direktes Verbinden (Direct-Bonding) aufgebracht. Damit entsteht der für ein Wärmerohr 3 benötigte Hohlraum in Form der Zwischenräume 15 zwischen den quadratischen Kupferflächen 14.

In einem dritten Arbeitsgang wird die aus der Kupferfolie 31.1, 31.2 und 32.1, 32.2 bestehende Metallisierung 4 auf der Keramikplatte 11 geätzt, so dass entsprechend der für die jeweilige Modulschaltung erforderlichen Leiterbahnstruktur voneinander isolierte Einzelflächen entstehen. Bei diesem Arbeitsgang werden gleichzeitig Eintrittsöffnungen 16 und Austrittsöffnungen 17 an geeigneten Stellen der Metallisierung 4 geätzt. Diese Öffnungen 16, 17 werden zum späteren Füllen der Wärmerohre 3 mit einer Flüssigkeit benötigt. Die Öffnungen 16, 17 können auch schon vorher durch Stanzen hergestellt werden. In diesem Fall müssen die Öffnungen 16, 17 beim Ätzvorgang mit einem geeigneten Klebeband dicht verklebt sein. Bei der späteren Füllung eines Wärmerohres 3 durch die Eintrittsöffnung 16 entweicht die verdrängte Luft durch die Austrittsöffnung 17. Wenn jedoch die Füllung nach einem Vakuumverfahren erfolgt, wird die Austrittsöffnung 17 nicht benötigt.

Im vierten Arbeitsgang werden die Oberflächen der Kupferfolien 32.1, 32.2 und gegebenenfalls 12 mit einem für die nächsten Montageschritte geeigneten Metall beschichtet. Es empfiehlt sich z.B. die Kupferfolien 32.1, 32.2 zu vernickeln, wenn anschliessend Leistungshalbleiterbauelemente 6 in Weichlöttechnik montiert werden sollen. Das Vernickeln kann galvanisch oder stromlos, also chemisch erfolgen. Dabei ist es zweckmässig, die Öffnungen 16, 17 vorher mit einer Folie zu verkleben, um anschliessend längere Waschprozesse zu vermeiden.

Im fünften Arbeitsgang werden Leistungshalbleiterbauelemente 6 z.B. als Sandwich, wie in Fig. 2 dargestellt, einschliesslich Kontaktbügel 10 oder sonstiger Bauteile, wie z.B. Kontaktanschlüsse aufgelötet. Bei diesem Lötvorgang können gleichzeitig kurze Rohrstutzen aus vernickeltem Messing oder Kupfer auf die Öffnungen 16, 17 aufgelötet werden, die das spätere Einfüllen der Flüssigkeit erleichtern.

Nachdem diese mit Wärmebehandlung verbundenen Arbeitsgänge abgeschlossen sind, erfolgt in einem sechsten Arbeitsgang das Einfüllen der für den Wärmetransport erforderlichen Flüssigkeit. Als Flüssigkeit wird deionisiertes Wasser bevorzugt, das sich in Niedertemperaturwärmerohren bereits bewährt hat. Geeignet sind aber auch Inertflüssigkeiten. Das Einfüllen der Flüssigkeit wird vereinfacht, wenn das Modul 1 auf etwa 90° bis 95 °C aufgeheizt ist, weil dann die Benetzung verbessert ist. Das Einfüllen kann mit einer einfachen Injektionsspritze erfolgen. Die optimale einzufüllende Menge wird durch Versuche ermittelt. Die Flüssigkeitsmenge muss mindestens so gross sein, dass die Heizzone des Wärmerohres während des Betriebs nicht austrocknet. Der Druck im Wärmerohr kann in gewissen Grenzen durch die Temperatur des Moduls 1 beim Verschliessen der Öffnungen 16, 17 eingestellt werden. Das Schliessen der Stutzen kann z.B. durch Verschrauben, Quetschen oder Verkleben erfolgen.

Als siebten und letzten Arbeitsgang folgt der Einbau des Modul 1 in ein Kunststoffgehäuse und das übliche Vergiessen des Modul 1.

Die Reihenfolge der Arbeitsgänge 6 und 7 kann vertauscht werden, wenn man entsprechend lange Einfüllstützen vorsieht.

Die vorstehend beschriebenen in einem Substrat 2 integrierten Wärmerohre 3 enthalten keine Kapillarstruktur für den Rücktransport der Arbeitsflüssigkeit zur Heizzone 50. Auf dem fertigen Leistungshalbleitermodul 1 muss deshalb angegeben werden, in welcher Einbaulage das Modul 1 arbeitsfähig ist. In Fig. 1 ist mit einem U und eine Pfeil angegeben, wo bei dem Ausführungsbeispiel unten ist.

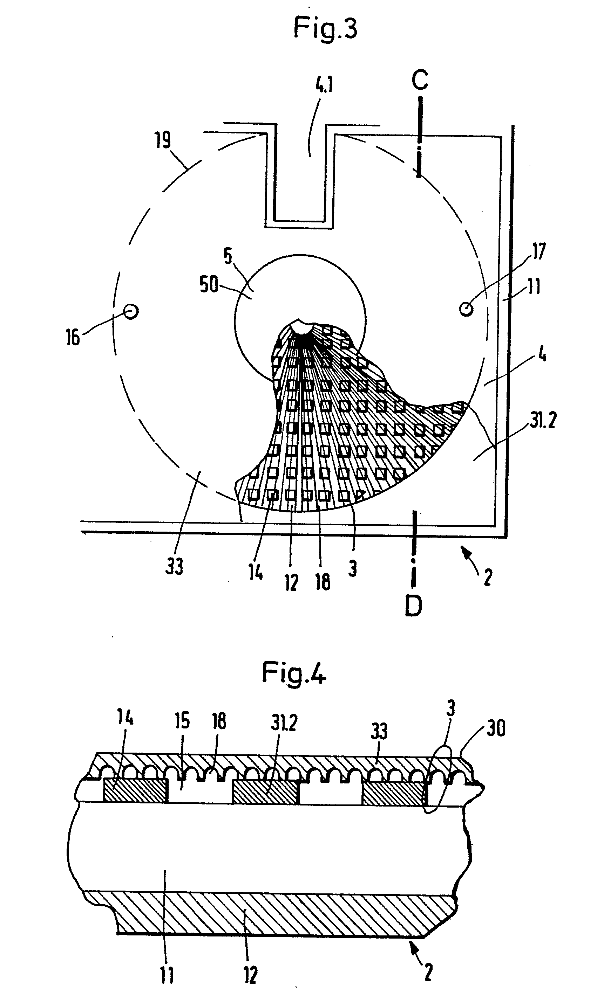

Ein zweites Ausführungsbeispiel ist in den Figuren 3 und 4 dargestellt. Dabei handelt es sich um die Integration eines mit Kapillaren 18 versehenen Wärmerohres 3 in das Substrat 2 eines lageunabhängig anwendbaren Leistungshalbleitermoduls 1.

Fig. 3 zeigt die Draufsicht auf einen Ausschnitt aus einem Leistungshalbleitermodul 1. Auch bei diesem Modul 1 geht man von einer etwa 0,63 mm bis 1,0 mm dicken Keramikplatte 11 aus, die auf der Unterseite mit einer etwa 0,3 mm dicken Kupferfolie 12 und auf der Oberseite mit einer etwa 0,4 mm dicken Kupferfolie 31.2 verbunden ist. Die obere Folie 31.2 wird wie beim ersten Ausführungsbeispiel geätzt, so dass in dem durch einen grossen mit gestrichelter Linie angedeuteten kreisrunden Kondensationsbereich 19 quadratische Flächen 14 mit Zwischenräumen 15 übrig bleiben. Der den Kondensationsbereich 19 angebende Kreis beschreibt die äussere Begrenzung des Wärmerohres 3, dessen Heizzone 50 durch den konzentrischen kleineren Kreis angegeben ist. Auf die vom kleinen Kreis bezeichnete Heizzone 50 auf der Metallisierung 4 wird das nicht dargestellte Leistungshalbleiterbauelement 6 mit seiner Grundfläche 5, die der Fläche der Heizzone 50 entspricht, aufgelötet. Die Metallisierung 4 hat somit z.B. Anodenpotential. Die angrenzende davon elektrisch isolierte Metallisierungsfläche 4.1 kann, wie in Fig. 3 dargestellt, so ausgestaltet werden, dass sie nahe an das Leistungshalbleiterbauelement 6 heranreicht und einen kurzen Kontaktbügel 10 (wie in Fig. 2 dargestellt) zwischen der Kathode des Leistungshalbleiterbauelements 6 und der Metallisierung 4.1 ermöglicht.

In Fig. 3 ist durc radiale Linien die Struktur von Kapillaren 18 angedeutet, die in dieser Darstellung eigentlich nicht sichtbar sind, da sich die Kapillaren 18 an der Unterseite einer in der Zeichnung aufgeschnittenen Kupferfolie 33 der Metallisierung 4 befinden. Mit dem radialen Verlauf der Kapillaren 18 soll erreicht werden, dass die Flüssigkeit von allen Seiten zur Heizzone 50 strömen kann.

Fig. 4 zeigt einen Schnitt durch die Ebene C–D in Fig. 3. Durch Vergleich mit dem Schnittbild Fig. 2 ist festzustellen, dass der einzige Unterschied im Aufbau darin besteht, dass die obere Kupferfolie 33 auf der der Folie 31.2 zugewandten Seite Kapillaren 18 aufweist. Die Kapillaren 18 für den Flüssigkeitstransport sollten etwa 0,1 mm breit und tief sein und die Folie 33 sollte etwa 0,3 mm dick sein. Die Struktur von radial verlaufenden Kapillaren 18 in der Folie 33 wird vorher durch Ätzen hergestellt. Die Kapillaren 18 sollen auch im äusseren Bereich des Kondensationsbereichs 19 angegebenen Fläche dicht nebeneinander liegen. Deshalb müssen die Kapillaren 18 nach innen zu in benachbarte Kapillaren 18 münden.

Die Herstellung des in den Figuren 3 und 4 dargestellten zweiten Ausführungsbeispiels des Leistungshalbleitermoduls 1 bzw. des dafür benötigten Substrats 2 mit integriertem Wärmerohr 3 in der Metallisierung 4 erfolgt wie zuvor für das in den Figuren 1 und 2 dargestellte erste Ausführungsbeispiel beschrieben. Es ist lediglich im zweiten Arbeitsgang anstelle der glatten Folie 32.1, 32.2 die einseitig mit Kapillaren 18 versehene Folie 33 zu verwenden.

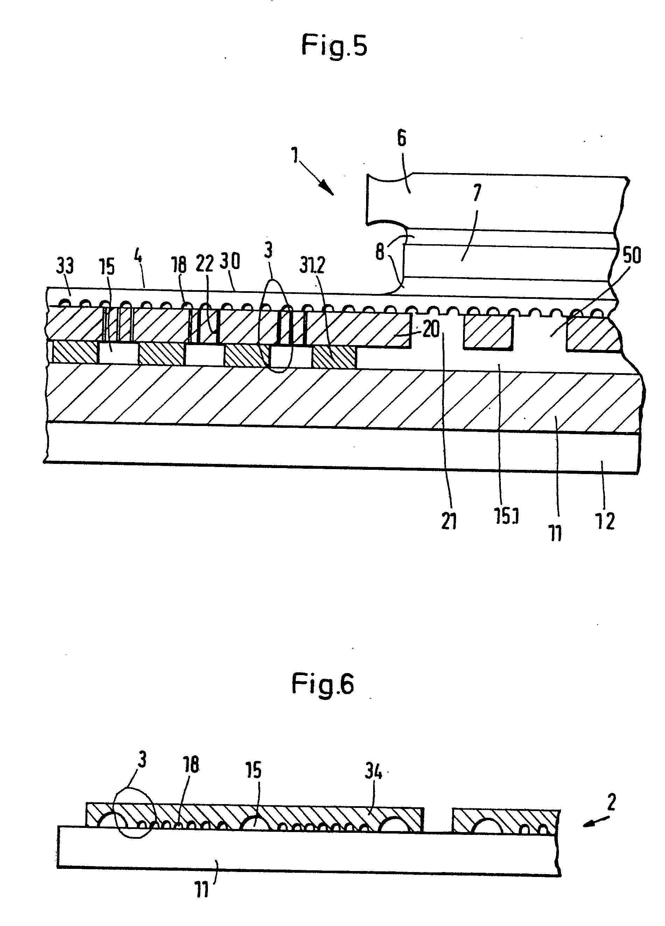

Ein drittes Ausführungsbeispiel ist in Fig. 5 dargestellt. Fig. 5 zeigt ein Schnittbild etwa wie Fig. 2 oder 4.

Bei dem dritten Ausführungsbeispiel eines Leistungshalbleitermoduls 1 ist eine Metallisierung 4 mit einem integrierten Wärmerohr 3 mit Kapillaren 18 wie beim zweiten Ausführungsbeispiel vorgesehen. Jedoch wird beim dritten Beispiel zwischen die strukturierte Folie 31.2 und die mit Kapillaren 18 versehene Folie 33 eine zweite Keramikplatte 20 im Bereich des Wärmerohres 3 oder der gesamten Metallisierung 4 eingebaut. Dies geschieht ebenfalls durch direktes Verbinden und zwar im zweiten Arbeitsgang vor dem Aufbringen der Folie 33. Die Keramikplatte 20 bringt eine höhere Stabilität und ermöglicht grössere Dampfräume im Bereich der Heizzone 50. Dies ist besonders bei hoher Verlustleistung des Leistungshalbleiterbauelements 6 vorteilhaft. In der Heizzone 50 des Wärmerohrs 3, also unter dem Leistungshalbleiterbauelement 6, weist die Keramikplatte 20 grössere Öffnungen 21 auf, die z.B. einen Durchmesser von 1 bis 2 mm haben. In diesem Bereich der Heizzone ist die darunterliegende Folie 31.2 vollständig weggeätzt, so dass ein vergrösserter Zwischenraum 15.1 entsteht. Ausserhalb der Heizzone 50, also im übrigen Kondensationsbereich 19, weist die Keramikplatte 20 kleine Öffnungen 22 auf, die etwa 0,1 mm Durchmesser haben. Aus dem Bereich der Zwischenräume 15 in der Folie 31.2 kann somit durch Kapillarkraft die Flüssigkeit durch die Öffnungen 22 und dann weiter durch die Kapillaren 18 in der Folie 33 zur Heizzone 50 unter dem Bauelement 6 transportiert werden. Die Kapillaren 18 verlaufen wie in Fig. 3 radial zur Mitte der Heizzone 50 (in Fig. 5 nicht darstellbar).

Für alle angeführten Beispiele gilt, dass die jeweils angegebene Fläche für den Kondensationsbereich 19 auch die Fläche einschliesst, in der die Heizzone 50 darüber angeordnet ist. Auch im Bereich der Heizzone 50, die von oben her vom Leistungshalbleiterbauelement 6 beheizt wird, kühlt nämlich die Keramikplatte 11.

In Fig. 6 ist in einem Schnittbild eines Substrats 2 ein viertes Beispiel für eine Ausführungsmöglichkeit eines in das Substrat 2 integrierten Wärmerohres 3 dargestellt. Dabei sind in eine Metallfolie 34 sowohl Kapillaren 18 als auch Dampfkanäle 15 nebeneinander geätzt und diese Folie 34 ist mit der geätzten Seite direkt mit einer Keramikplatte 11 verbunden.

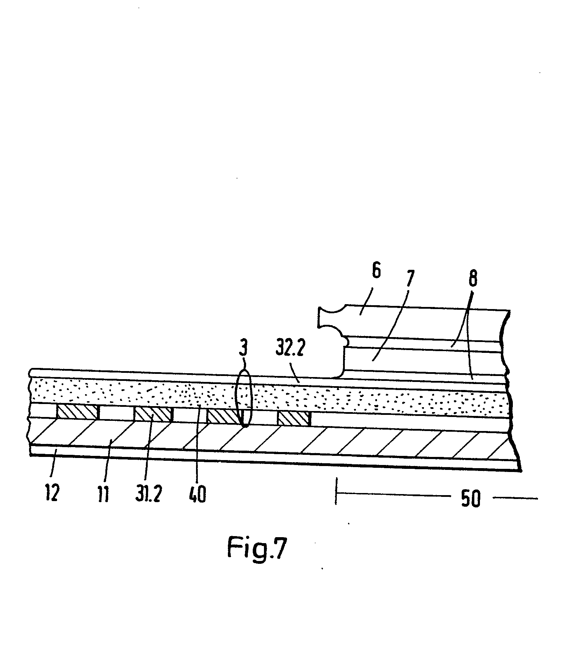

Ein fünftes Beispiel ist in Fig. 7 dargestellt. Dabei ist über der Keramikplatte 11 eine strukturierte Metallfolie 31.2 vorgesehen, die im Bereich der Heizzone 50 vollständig weggeätzt ist. Darüber ist eine poröse Keramikplatte 40 und schliesslich darüber eine glatte Metallfolie 32.2. Durch die poröse Keramikplatte 40 erfolgt der Rücktransport der Arbeitsflüssigkeit zur Heizzone 50.

Selbstverständlich handelt es sich bei den vorgenannten Ausführungsbeispielen nur um beispielhafte Gestaltungen. Die für den jeweiligen Anwendungsfall optimalen Abmessungen sind durch Berechnung und Versuche zu ermitteln. Ausser dem direkten Verbinden sind z.B. auch Weichlöten oder Hartlöten geeignete Verfahren (wobei man von dickschicht-metallisierten Keramikplatten ausgeht).

Die Erfindung ist nicht auf Module mit mehreren Bauelementen beschränkt, sondern ist auch für den isolierten Aufbau einzelner Bauelemente geeignet.

**Patentansprüche**

1. Leistungshalbleitermodul mit einem oder mehreren Leistungshalbleiterbauelementen, die auf ein Substrat aus metallisierter Keramik aufgelötet sind, und mit mindestens einem im Leistungshalbleitermodul integrierten Wärmerohr, das die vom Leistungshalbleiterbauelement abzuführende Wärme auf eine im Vergleich zur Grundfläche des Leistungshalbleiterbauelements grössere Fläche eines Kondensationsbereiches des Wärmerohres verteilt, dadurch gekennzeichnet, dass das Wärmerohr (3) in die Metallisierung (4) der dem Leistungshalbleiterbauelement (6) zugewandten Seite (30) des Substrats (2) integriert ist.

2. Leistungshalbleitermodul nach Anspruch 1, dadurch gekennzeichnet, dass das Wärmerohr (3) gebildet ist durch eine strukturierte Metallfolie (31.2) auf einer Keramikplatte (11) und einer glatten Metallfolie (32.2) über der strukturierten Folie (31.2), wobei die strukturierte Metallfolie (31.2) zwischen Metallflächen (14) zusammenhängende Zwischenräume (15) für den Dampf- und Flüssigkeitstransport aufweist.

3. Leistungshalbleitermodul nach Anspruch 1, dadurch gekennzeichnet, dass das Wärmerohr (3) gebildet ist durch eine strukturierte Metallfolie (31.2) auf einer Keramikplatte (11) und einer weiteren Metallfolie (33), die auf einer Seite Kapillare (18) aufweist und mit dieser Seite mit der strukturierten Folie (31.2) verbunden ist.

4. Leistungshalbleitermodul nach Anspruch 1, dadurch gekennzeichnet, dass das Wärmerohr (3) gebildet ist durch folgende Schichten über der Keramikplatte (11):

– strukturierte Metallfolie (31.2)
– zweite Keramikplatte (20) mit grösseren Öffnungen (21) im Bereich der Heizzone (50) des Wärmerohres (3) und kleineren Öffnungen (22) im Kondensationsbereich des Wärmerohres (3),
– weitere Metallfolie (33) mit Kapillaren (18), die radial vom Mittelpunkt der Heizzone (50) des Wärmerohres (3) ausgehen, wobei die mit Kapillaren (18) versehene Seite der Folie (33) der zweiten Keramikplatte (20) zugewandt ist.

5. Leistungshalbleitermodul nach Anspruch 1, dadurch gekennzeichnet, dass das Wärmerohr (3) gebildet ist durch folgende Schichten über der Keramikplatte (11):
– strukturierte Metallfolie (31.2),
– poröse Keramikplatte (40)
– glatte Metallfolie (32.2)

6. Leistunsgshalbleitermodul nach Anspruch 1, dadurch gekennzeichnet, dass das Wärmerohr (3) gebildet ist durch eine Metallfolie (34), die auf einer Seite sowohl Kanäle (15) für den Dampftransport als auch Kapillare (18) für den Flüssigkeitstransport nebeneinander aufweist und mit ihrer strukturierten Seite direkt mit einer Keramikplatte (11) verbunden ist.

7. Leistungshalbleitermodul nach einem der Ansprüche 1 bis 6, dadurch gekennzeichnet, dass die Keramikplatte (11) auf der Unterseite eine glatte Metallfolie (12) aufweist.

8. Leistungshalbleitermodul nach einem der Ansprüche 1 bis 7, dadurch gekennzeichnet, dass Verbindungen zwischen Keramikplatten (11, 20) und Metallfolien (12, 31.1, 31.2, 32.1, 32.2, 33, 34) durch Direct-Bonding hergestellt sind.

9. Leistungshalbleitermodul nach einem der Ansprüche 1 bis 8, dadurch gekennzeichnet, dass es sich bei den Metallfolien (12, 31.1, 31.2, 32.1, 32.2, 33, 34) um Kupferfolien handelt.

10. Leistungshalbleitermodul nach einem der Ansprüche 1 bis 9, dadurch gekennzeichnet, dass im Wärmerohr (3) als Arbeitsflüssigkeit deionisiertes Wasser verwendet ist.

11. Leistungshalbleitermodul nach einem der Ansprüche 1 bis 10, dadurch gekennzeichnet, dass im Wärmerohr (3) als Arbeitsflüssigkeit eine Inertflüssigkeit verwendet ist.

## Revendications

1. Module semiconducteur de puissance comprenant un ou plusieurs éléments semiconducteurs de puissance, qui sont soudes sur un substrat en céramique métallisée, et au moins un caloduc intégré dans le module semiconducteur de puissance, qui répartit la chaleur à évacuer de l'élément semiconducteur de puissance sur une surface d'une zone de condensation du caloduc, qui est plus grande par rapport à la surface de base de l'élément semiconducteur de puissance, caractérisé en ce que le caloduc (3) est intégré dans la métallisation (4) de la face (30) du substrat (2) tournée vers l'élément (6) semiconducteur de puissance.

2. Module semiconducteur de puissance selon la revendication 1, caractérisé en ce que le caloduc (3) est formé par une feuille métallique structurée (31.2) sur une plaque en céramique (11) et par une feuille métallique (32.2) lisse sur la feuille structurée (31.2), la feuille métallique structurée (31.2) comportant entre des surfaces métalliques (14) des interstices (15) reliés les uns aux autres en vue du transport de vapeur et de liquide.

3.Module semiconducteur de puissance selon la revendication 1, caractérisé en ce que le caloduc (3) est formé par une feuille métallique structurée (31.2) sur une plaque en céramique (11) et par une autre feuille métallique (33) qui comporte des capillaires (18) sur une face et est reliée par cette face à la feuille structurée (31.2).

4. Module semiconducteur de puissance selon la revendication 1, caractérisé en ce que le caloduc (3) est formé par les couches suivantes disposées au-dessus de la plaque en céramique (11):
– une feuille métallique structurée (31.2),
– une deuxième plaque en céramique (20) avec des ouvertures (21) plus grandes dans la zone de chauffage (50) du caloduc (3) et des ouvertures (22) plus petites dans la zone de condensation du caloduc (3),
– une autre feuille métallique (33) avec des capillaires (18) qui partent radialement du centre de la zone de chauffage (50) du caloduc (3), la face de la feuille (33) qui est pourvue de capillaires (18) étant tournée vers la deuxième plaque en céramique (20).

5. Module semiconducteur de puissance selon la revendication 1, caractérisé en ce que le caloduc (3) est formé par les couches suivantes disposées au-dessus de la plaque en céramique (11):
– une feuille métallique structurée (31.2),
– une plaque en céramique (40) poreuse,
– une feuille métallique lisse (32.2).

6. Module semiconducteur de puissance selon la revendication 1, caractérisé en ce que le caloduc (3) est formé par une couche métallique (34) qui comporte sur une face les uns à côté des autres aussi bien des canaux (15) pour le transport de la vapeur que des capillaires (18) pour le transport du liquide et est reliée par sa face structurée directement à une plaque en céramique (11).

7. Module semiconducteur de puissance selon l'une quelconque des revendications 1 à 6, caractérisé en ce que la plaque en céramique (11) comporte sur sa face inférieure une feuille métallique lisse (12).

8. Module semiconducteur de puissance selon l'une quelconque des revendications 1 à 7, caractérisé en ce que des liaisons entre les plaques en céramique (11, 20) et les feuilles métalliques (12, 31.1, 31.2, 32.1, 32.2, 33, 34) sont établies par liaison directe (Direct-Bonding).

9. Module semiconducteur de puissance selon l'une quelconque des revendications 1 à 8, caractérisé en ce que les feuilles métalliques (12, 31.1, 31.2, 32.1, 32.2, 33, 34) sont des feuilles en cuivre.

10. Module semiconducteur de puissance selon l'une quelconque des revendications 1 à 9, caractérisé en ce que de l'eau désionisée est utilisée comme liquide de travail dans le caloduc (3).

11. Module semiconducteur de puissance selon l'une quelconque des revendications 1 à 10, caractérisé en ce qu'un liquide inerte est utilisé comme liquide de travail dans le caloduc (3).

## Claims

1. Power semiconductor module containing one or more power semiconductor components which are soldered onto a substrate of metallized ceramic, and containing at least one heat pipe, incorporated in the power semiconductor module, which distributes the heat to be removed from the power semiconductor component over an area of a condensation region of the heat pipe which is large compared with the base surface of the power semiconductor component, characterized in that the heat pipe (3) is incorporated in the metallization (4) of the side (30) of the substrate (2) facing the power semiconductor component (6).

2. Power semiconductor module according to Claim 1, characterized in that the heat pipe (3) is formed by a patterned metal foil (31.2) on a ceramic plate (11) and a smooth metallic foil (32.2) on top of the patterned foil (31.2), the patterned metal foil (31.2) having connecting interstices (15) between metal areas (14) for conveying vapour and liquid.

3. Power semiconductor module according to Claim 1, characterized in that the heat pipe (3) is formed by a patterned metal foil (31.2) on a ceramic plate (11) and a further metal foil (33) which has capillaries (18) on one side and is connected by means of this side to the patterned foil (31.2).

4. Power semiconductor module according to Claim 1, characterized in that the heat pipe (3) is formed by the following layers on top of the ceramic plate (11):
– patterned metal foil (31.2),
– second ceramic plate (20) with fairly large openings (21) in the region of the hot zone (50) of the heat pipe (3) and smaller openings (22) in the condensation region of the heat pipe (3),
– further metal foil (33) with capillaries (18) which radiate from the centre of the hot zone (50)

of the heat pipe (3), the side of the foil (33) provided with capillaries (18) facing the second ceramic plate (20).

5. Power semiconductor module according to Claim 1, characterized in that the heat pipe (3) is formed by the following layers on top of the ceramic plate (11):
- patterned metal foil (31.2)
- porous ceramic plate (40),
- smooth metal foil (32.2).

6. Power semiconductor module according to Claim 1, characterized in that the heat pipe (3) is formed by a metal foil (34) which has on one side both channels (15) for conveying vapour and also capillaries (18) for conveying liquid next to each other and which is joined by means of its patterned side directly to a ceramic plate (11).

7. Power semiconductor module according to one of the Claims 1 to 6, characterized in that the ceramic plate (11) has a smooth metal foil (12) on the bottom side.

8. Power semiconductor module according to one of the Claims 1 to 7, characterized in that joints between ceramic plates (11, 20) and metal foils (12, 31.1, 31.2, 32.1, 32.2, 33, 34) are produced by direct bonding.

9. Power semiconductor module according to one of the Claims 1 to 8, characterized in that the metal foils (12, 31.1, 31.2, 32.1, 32.2, 33, 34) are copper foils.

10. Power semiconductor module according to one of the Claims 1 to 9, characterized in that deionized water is used in the heat pipe (3) as working liquid.

11. Power semiconductor module according to one of the Claims 1 to 10, characterized in that an inert liquid is used in the heat pipe (3) as working liquid.

## Fig.1

## Fig.2

## Fig.3

## Fig.4

Fig.5

Fig.6

Fig.7